# EUROPEAN PATENT APPLICATION

(11) **EP 4 579 726 A2**
(43) Date of publication of application: **02.07.2025**
(21) Application number: 24207031.6
(22) Date of filing: 16.10.2024
(51) Int. Cl.: H01L 23/00

(54) **SEMICONDUCTOR PACKAGE SUBSTRATE DICING AND EDGE PASSIVATION**

(30) Priority: 26.12.2023 US 202318395937
(71) Applicant: INTEL Corporation, Santa Clara, CA 95054 (US)
(72) Inventor: LI, Yonggang Yong, Chandler, 85248 (US); RAMANUJA PIETAMBARAM, Srinivas Venkata, Chandler, 85249 (US); DUAN, Gang, Chandler, 85248 (US); NDUKUM, Tchefor, Chandler, 85248 (US); MCREE, Robin, Chandler, 85286 (US); BRYKS, Whitney, Tempe, 85284 (US); GARELICK, Aaron, Chandler, 85226 (US); KANG, Zheng, Chandler, 85249 (US); LI, Yi, Chandler, 85225 (US); ZHANG, Anqi, Chandler, 85226 (US); SREERAMAGIRI, Praveen, Gilbert, 85297 (US); EL KHATIB, Ibrahim, Chandler, 85226 (US); JONES, Jesse, Chandler, 85248 (US)
(74) Representative: HGF

(57) **Abstract**

Processes and process equipment for modifying edges of semiconductor package substrates, and semiconductor package substrates having modified edges are provided. The processes and process equipment are especially useful for semiconductor package substrates that have cores that can crack or chip during processing, such as, for example, cores comprised of glass. Semiconductor package substrates having glass cores and modified edges are also provided.

## Description

### FIELD

Descriptions are generally related to semiconductor manufacturing, and more particular descriptions are related to equipment and methods for singulating semiconductor package substrates and coating edges of semiconductor package substrates. Semiconductor package substrates having coated edges are also provided.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, material failures, precision and scaling requirements, power delivery requirements, limited failure tolerance, and material and manufacturing costs.

Advanced packaging solutions, such as the heterogeneous integration of active components, can improve performance and functionality of semiconductor devices and systems. Heterogeneous integration integrates dissimilar semiconductor chips having different functions in one package using, for example, lateral or vertical connections. A design model for improving device and system performance focuses on chip stacking using thinned chips and increasing input/output (I/O) density for multichip integration. Manufacturing these types of packages is facilitated by a rigid carrier wafer, such as a glass wafer, to which packages being manufactured are temporarily bonded and then debonded. A temporary rigid glass substrate can enable handling of thinned semiconductor chips, such as during the grinding of dielectric materials to reveal lithographically formed plated vias (LIVs). Further, the low total thickness variation (TTV) of less than or equal to 10 µm that can be associated with glass can enable stringent via to pad overlay requirements.

### BRIEF DESCRIPTION OF THE DRAWINGS

The figures are provided to aid in understanding the invention. The figures can include diagrams and illustrations of exemplary structures, assemblies, data, methods, and systems. For ease of explanation and understanding, these structures, assemblies, data, methods, and systems, the figures are not an exhaustively detailed description. The figures therefore should not be understood to depict the entire metes and bounds of structures, assemblies, data, methods, and systems possible without departing from the scope of the invention. Additionally, features are not necessarily illustrated relatively to scale due in part to the small sizes of some features and the desire for clarity of explanation in the figures.
**Figures 1** illustrates an exemplary system useful for singulating package substrate units that have been manufactured in panel form.
**Figure 2** illustrates an exemplary polymer ablation module.
**Figures 3** shows an exemplary singulation conditioning module useful for preparing panels comprising package substrates for singulation.
**Figure 4** illustrates an exemplary separation module for singulating panels into package substrates.
**Figure 5** provides an additional exemplary separation module for singulating panels into package substrates.
**Figures 6A** - **6B** illustrate an exemplary edge treatment module that can perform a mechanical edge grinding on a package substrate.
**Figure 7** shows an exemplary edge treatment module that employs a laser to modify the edges of a package substrate.
**Figure 8** provides an example of an edge passivation module that can apply a polymer coating to a semiconductor package substrate edge.
**Figures 9A** - **9B** provide an additional example of an edge passivation module that can apply a thermoplastic coating to a semiconductor package substrate edge.
**Figures 10A - 10B** illustrate a further example of an edge passivation module that can apply a ultra-violet-radiation-curable (UV curable) coating to a semiconductor package substrate edge.
**Figures 11A** - **11B** show a further example of an edge passivation module that can apply a coating to a semiconductor package substrate edge.
**Figure 12** provides an additional example of an edge passivation module that can apply a coating to a semiconductor package substrate edge.
**Figure 13** describes methods for singulating semiconductor package substrates from a panel, that are useful for semiconductor package substrates that have a glass core.
**Figure 14** describes methods for modifying the edges of a semiconductor package substrate.
**Figures 15A** - **15C** illustrate some exemplary semiconductor package substrates.
**Figure 16** provides an exemplary computing system.

Descriptions of certain details and implementations follow, including non-limiting descriptions of the figures, which depict some examples and implementations.

### DETAILED DESCRIPTION

References to one or more examples are to be understood as describing a particular feature, structure, or characteristic included in at least one implementation of the invention. The phrases "one example" or "an example" are not necessarily all referring to the same example or embodiment. Any aspect described herein can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following after some other event or events. Other sequences of operations can also be performed according to alternative embodiments. Furthermore, additional operations may be added or removed depending on the particular application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain embodiments require at least one of X, at least one of Y, or at least one of Z to each be present.

Terms such as chip, die, IC (integrated circuit) chip, IC die, microelectronic chip, microelectronic die, and/or semiconductor chip are interchangeable and refer to a semiconductor device comprising integrated circuits.

The terms "package," "packaging," "IC package," or "chip package," "microelectronics package," or "semiconductor chip package" are interchangeable and generally refer to an enclosed carrier of one or more dies, in which the dies are attached to a package substrate and encapsulated. The package substrate provides electrical interconnects between the die(s) and other dies and/or a motherboard or other printed circuit board for I/O (input/output) communication and power delivery. A package with multiple dies can, for example, be a system in a package.

A package substrate generally includes dielectric layers or structures having conductive structures on, through, and/or embedded within the dielectric layers or structures. The dielectric layers can be, for example, build-up layers. Other structures or devices are also possible within a package substrate. Semiconductor package substrates can have cores or be coreless. Semiconductor packages having cores can have dielectric layers such as buildup layers on more than one side of a core, such as on two opposite sides of a core.

A "core" or "package core" generally refers to a layer usually embedded within a package substrate. The core can provide structure or stiffness to a package substrate. A core is an optional feature of a package substrate. The core can be a dielectric organic or inorganic material and may have conductive vias extending through the layer. The conductive vias can include a metal, for example, copper. A package core can, for example, be comprised of a glass material (such as, for example, aluminosilicate, borosilicate, alumino-borosilicate, silica, and fused silica), silicon, silicon nitride, silicon carbide, gallium nitride, or aluminum oxide. In some examples, core materials are glass-fiber reinforced organic resins such as epoxy-based resins. A further example package substrate core is FR4 (woven glass fiber reinforces epoxy). In other examples, package substrate cores are solid amorphous glass materials.

In further examples of a package substrate core, the substrate core is a glass core comprising a solid amorphous glass material. The glass substrate core can comprise a glass such as, for example, aluminosilicate, borosilicate, alumino-borosilicate, silica, and fused silica, that additionally optionally comprises one or more of the following: Al₂O₃, B₂O₃, MgO, CaO, SrO, BaO, SnO₂, Na₂O, K₂O, SrO, P₂O₃, ZrOz, LizO, Ti, and/or Zn. In further examples of glass cores, the glass can comprise silicon and oxygen, as well as optionally any one or more of: aluminum, boron, magnesium, calcium, barium, tin, sodium, potassium, strontium, phosphorus, zirconium, lithium, titanium, and/or zinc. In some examples, a glass package substrate core comprises at least 23 % silicon, at least 26 % oxygen by weight. In further examples, the glass package substrate core comprises at least 23 % silicon, at least 26 % oxygen, and at least 5 % aluminum by weight.

Additionally, exemplary solid amorphous glass substrate cores can be considered to have a rectangular prism volume. The rectangular prism volume can contain vias that have been filled with one or more different materials. A material in a via can be a conducting metal such as copper. Exemplary solid amorphous glass substrate cores can have a thicknesses in the range of 50 µm to 1.4 mm. Additionally, the package substrate can include a multi-layer glass substrate. The package substrate in this example may be a coreless substrate. The multi-layer glass substrate can have a thickness, for example, in the range of 25 µm to 50 µm. Further, glass substrate cores can have dimensions on a side of 10 mm to 250 mm. For example, the substrate core could be 10 mm by 10 mm up to 250 mm by 250 mm in two dimensions, but substrate cores do not necessarily have to have the same value in both dimensions.

One of the challenges associated with temporary bonding and debonding of semiconductor device packages is warpage or shrinkage after the removal of the rigid carrier. Once a rigid carrier, such as a glass carrier, is debonded post first level interconnect (FLI) bump formation, the substrate can warp due to inbuilt residual stress and coefficient of thermal expansion (CTE) mismatches. For example, silicon has a CTE of 2.6 ppm/°C, Ajinomoto build-up film (ABF) has a CTE of about 39 ppm/°C, and Cu has a CTE of 17 ppm/°C. (ABF is a common dielectric used in package substrate manufacturing.) These CTE mis-matches can impact back-end processes for mid-level interconnect (MLI) bump formation and also the assembly thermal compression bonding (TCB) processes. Using glass as a package substrate core can facilitate maintaining the package substrate TTV for bump pitch scaling.

During a substrate manufacturing flow, glass-cored substrates can be handled by process equipment as many as hundreds of times. Glass can be a fragile material and can make the substrate manufacturing process flow challenging. For example, when the panel edge is contacted by a process tool, the contact increases the risk of chips and cracks that can propagate through the glass substrate core.

At the end of package substrate manufacturing, a package substrate unit is singulated from a panel that comprises many substrate units before moving to die assembly. Fine chips and defects can be generated in package substrate glass cores during the singulation process. These fine chips and defects can release built up stress from material CTE mismatches in the package and can lead to glass core splitting. Singulation methods using blade dicing can also impart in-plane dicing defects which can lead to the splitting of a glass package substrate core.

The package substrate manufacturing process is typically a buildup process that adds alternating layers of materials such as Cu and dielectric which are placed on a glass core through several thermal processes. These manufacturing processes place an enormous amount of tensile stress on a glass package substrate core, which can result in a normal stress at the edge of the panel and/or package substrate unit. The process of cutting a panel into individual package substrate units can result in fine cracks and defects along the glass substrate core edge. These cracks may be large enough to release the built up stress, resulting in package substrate failure due to core separation.

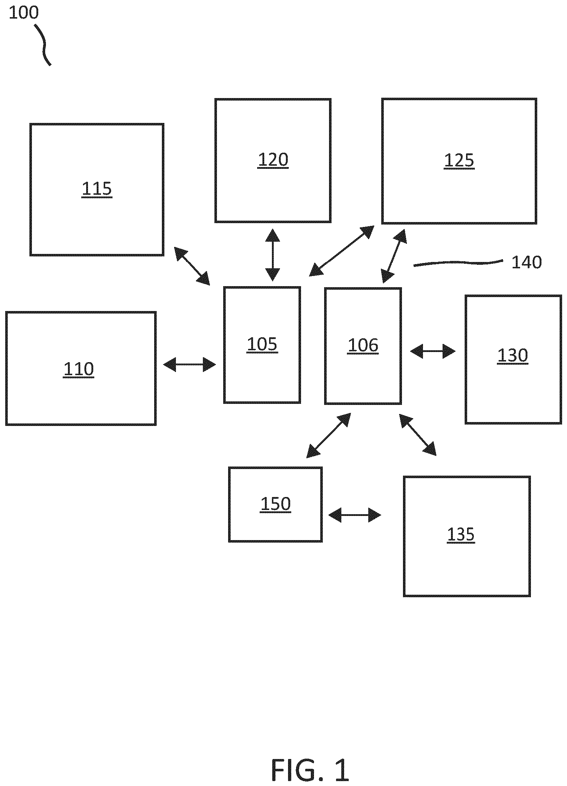

Figure 1 diagrams an exemplary system for singulating package substrate units from a panel where they are housed during manufacturing. The exemplary system of Figure 1 is useful, for example, for singulating package substrates that have glass cores. The components of the singulation system 100 can provide a controlled atmosphere for panel and unit processing inside a housing. A controlled atmosphere can be an inert atmosphere, vacuum, and/or clean room compliant International Standards Organization (ISO 100), or any other environment as the process or room requires. The singulation system 100 comprises equipment front end modules (EFEMs) or pick and place systems 105 and 106 that handle moving panel and/or sub-panel form factors, such as, for example, quarter panel form factors, into equipment for processing. The EFEMs or pick and place systems 105 and 106 can comprise one or more robotic arms that can pick a panel or package substrate unit and place it on chucks or tables in selected processing equipment. The EFEM 105 can handle panels and the EFEM 106 can handle singulated package substrates, for example. Depending on configuration, there can be more than two EFEMs and/or pick and place systems 105 and 106. The system can also include one or more JEDEC (Joint Electron Device Engineering Council) tray elevators (not shown). Further, any of the

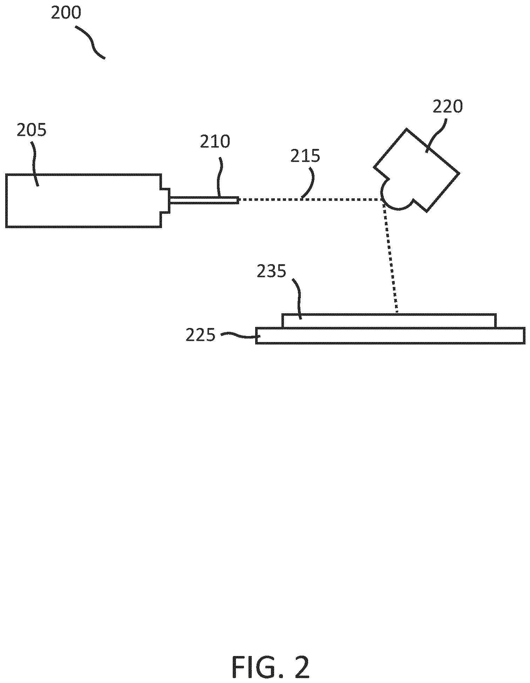

The singulation system 100 also can include a polymer ablation module 110. The polymer ablation module 110 removes package materials, such as, for example, dielectrics from the glass core surface in between individual package substrate units. The polymer ablation module 110 comprises, for example, a laser, optics for routing the laser beam, and a galvo-scanner for moving the laser beam to selected ablation areas. The polymer ablation module 110 is described further in Figure 2 and accompanying description herein. After ablating packaging manufacturing materials in areas between package substrates on a first side of the panel (or partial panel), the panel can optionally be flipped so that the same operation can be performed on the opposite side of the panel. The polymer ablation module 110 can also comprise a flipping device and second table. The panel can optionally be flipped and placed on a second table. Ablating package materials from between the package substrates can leave a substrate core surface exposed in the region between package substrates.

The exemplary singulation system 100 can also optionally include a tape lamination module 115. A tape laminated onto the substrate-containing panel can be useful during the singulation process. The tape that is laminated can be, for example, an ultra violet (UV) release tape. A UV release tape is one that releases on exposure to UV light. The tape lamination module 115 can include a housing, worktable having a vacuum chuck that is capable of holding a substrate-containing panel in place, and a tape laminator capable of placing tape on the glass package substrate core in the regions that have been exposed by laser ablation of polymer (not shown).

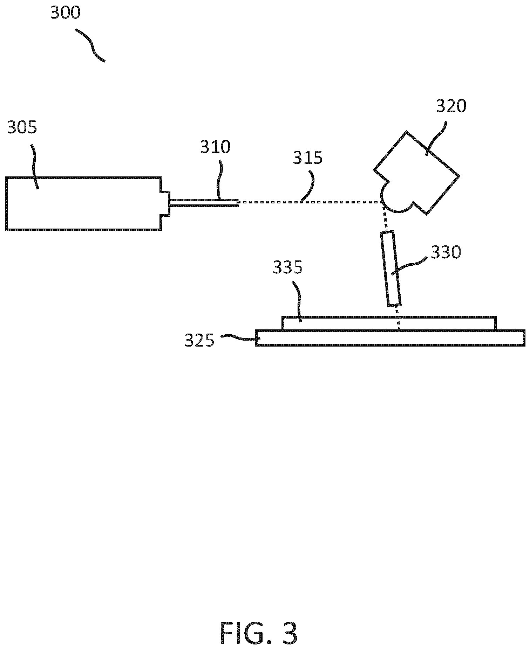

The exemplary singulation system 100 can also include a singulation conditioning module 120. An exemplary singulation conditioning module is described in additional detail in and with respect to Figure 3. Filamentation or Bessel beam processes, for example, can be used to modify the package substrate core material between the package substrates that are housed on a panel. The package substrate core material is, for example, a glass material, such as those described herein. Filamentation uses Kerr effect to attain a self-focused beam in a solid medium, such as the glass core material. The filamentation works by focusing, creating a plasma separating material, defocusing, and self-focusing until the thickness (width) of the glass is modified. A Bessel beam uses an axicon lens to focus a single collimated laser beam into a thin line having a high aspect ratio. Controlling the aspect ratio of the laser beam can allow the thickness of glass to be modified by traversing the panel singulation regions (that are between package substrates) one time with the laser beam. In the alternative, multiple passes of the laser beam over the panel singulation regions can be performed. A curtain of filaments creates a modified glass structure that is easier to separate.

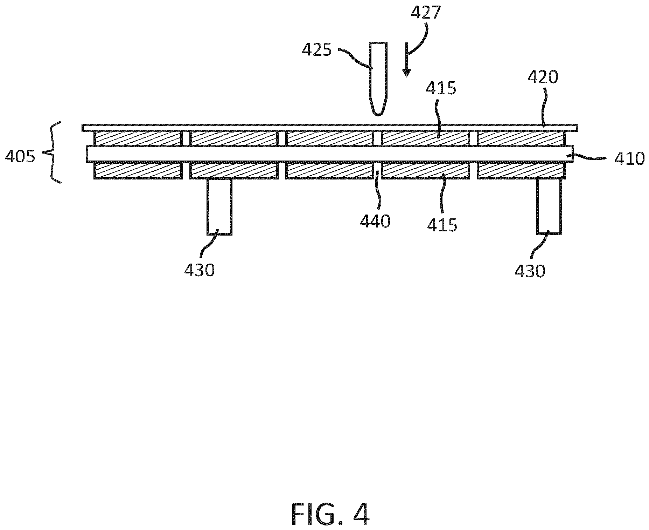

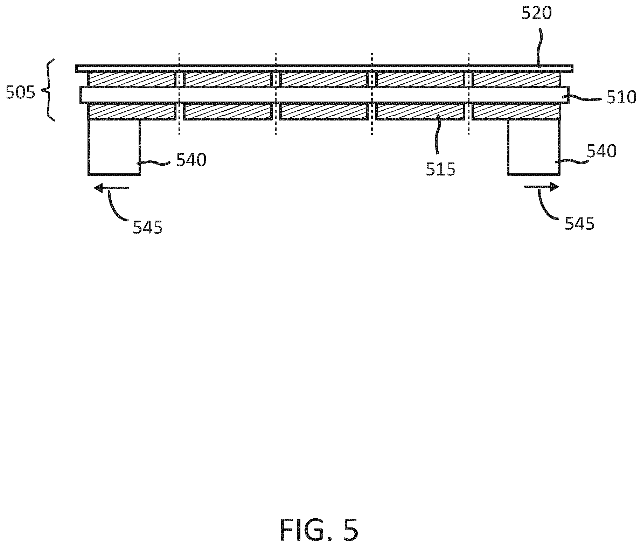

A separation module 125 singulates the panel to create individual package substrates. Laser glass modification, performed in, for example the singulation conditioning module 120, can render the glass between the individual package substrates brittle, so that a small amount of force is needed to separate the glass. The separation of the glass can be accomplished through, for example, a bend-to-break process, a bend and pull process, a laser separation process, or a pull-to-break process. Other methods of separation are possible. A bend-to-break process and a pull-to-break process can use tape lamination. The exemplary singulation system 100 also optionally includes a tape lamination module 115 or a jig to perform the separation without a tape lamination. The exemplary separation module 125 can employ one of the mentioned separation methods or a different one. A bend-to-break process can use a bending pin or a jig to push through the laser-modified areas to separate the glass. Figure 4 illustrates a bending-to-break process and shows some of the components of the separation module 125 that can perform a bend-to-break process. Figure 5 illustrates additional aspects of a pull-to-break process and shows components of an exemplary separation module 125 that can perform a pull-to-break process. The pull-to-break process can separate packaging units and create a gap between them. A laser separation process employs a laser that is capable of subjecting panel singulation regions (that are between package substrates) to a thermal stress to cause the region to expand and contract. The laser system can be a laser system described herein, and for example, one with respect to Figures 2 and 3.

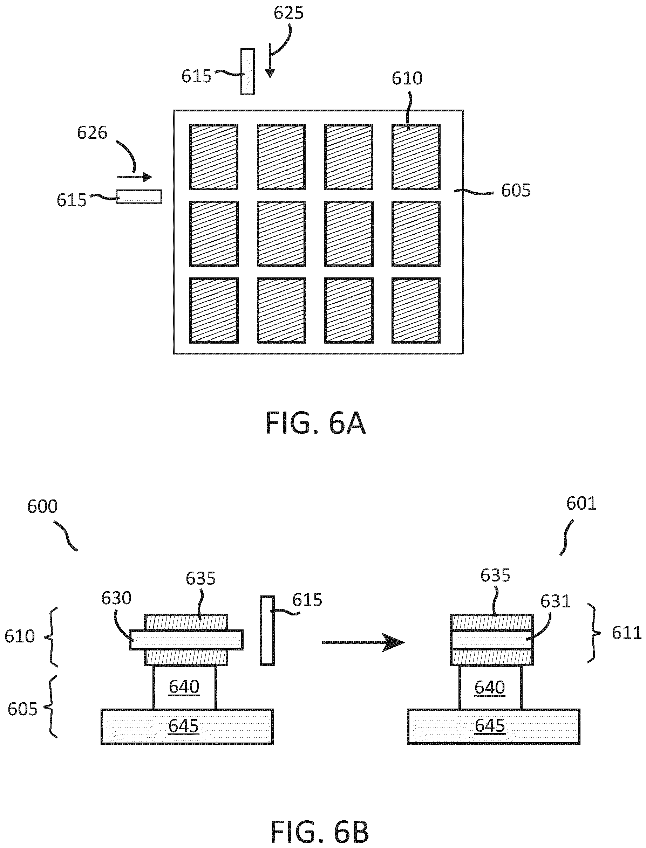

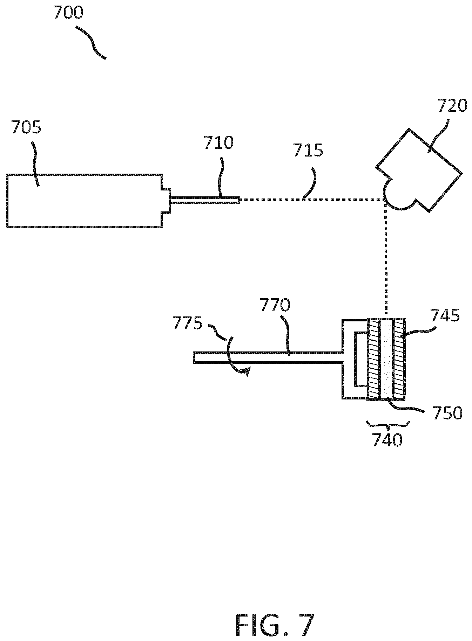

The singulation system 100 also includes an optional edge treatment module 130 in which grinding or polishing of the package substrate edges can be performed. After singulation of the package substrates, there is a possibility of crack formation in the substrate core. An edge grinding can be performed to remove package substrate core damage. Figures 6A - 6B illustrate an edge treatment module 130 that performs mechanical edge grinding. Alternatively, edge treatment of package substrates can be performed by a laser, such as a UV, an IR, or a CO₂ laser. The laser edge treatment can consist of removing materials from the edges of package substrates, melting the edges, or a combination of removal and melting. Melting the edges can create a mirror finish. The laser edge treatment can remove cracks from a package substrate core. The laser edge treatment can also leave the edges of the core flush with the packaging material on the core. Figure 7 illustrates an example of an edge treatment module employing a laser.

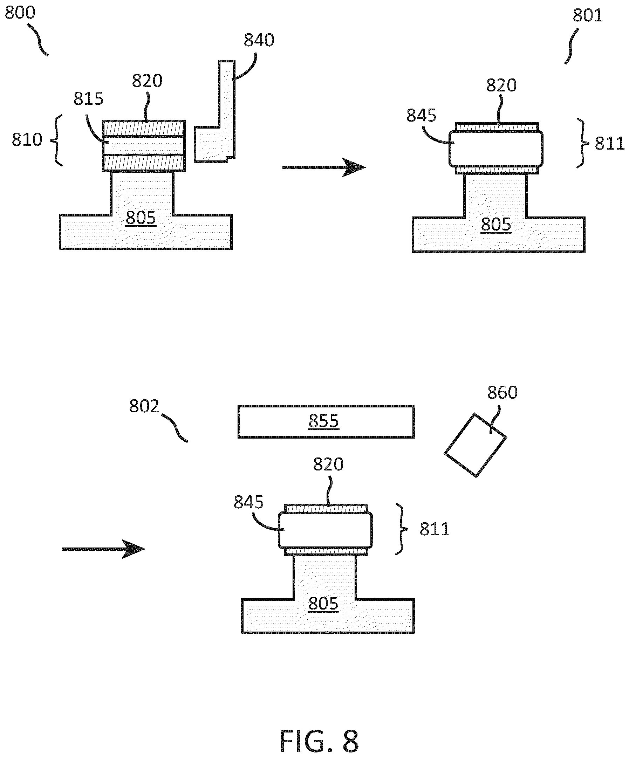

A singulation system 100 can also optionally include an edge passivation module 135. An edge passivation module 135 can encapsulate the edges of a semiconductor package substrate. Encapsulation can reduce further damage to the package substrate caused by impacts, it can fill in flaws on the edge, and/or it can apply a compressive stress to mitigate tensile stresses in the package substrate. Figures 8, 9A - 9B, 10A - 10B, 11A - 11B and 12 and descriptions herein provide several different exemplary types of edge passivation modules 135 that are possible.

An exemplary singulation system 100 can also optionally include a semiconductor package substrate inspection module 150. A semiconductor package inspection module 150 can employ vacuum pick heads to pick up the semiconductor package substrate units from a transfer tray or coating module. A pick and place can be used to inspect the semiconductor package substrate units. Semiconductor package substrate units can be inspected to ensure dimensional (and other) compliance to determined standards and tolerance levels by comparing measured values with desired values. Besides dimensional tolerance, such as warpage, the inspection can encompass an inspection that looks for cracks, chipping, and damage from singulation and other processing. The inspection module 150 can contain a single camera or multiple cameras and profilers looking at the surface and edges of the semiconductor package substrate units. In addition, a machine learning algorithm can be trained and used to employ criteria for determining functional versus non-functional semiconductor package substrate units. Post inspection, the functional units can be placed in the good unit tray, while the rejected units can be placed in the reject trays. One or more inspection modules 150 can also be associated with or integral with any of the processing modules 110, 115, 120, 125, 130, and 135.

Arrows 140 show some possible ways work pieces, such as panels comprising package substrates, can be transferred between processing modules 110, 115, 120, 125, 130, and 135 and inspection module 150. Other layouts and interconnections are possible, depending on the different modules employed and the different semiconductor package substrate transfer options selected for transfer in between processing and inspection modules. One or more different modules can be selected from the singulation system 100 to be used for semiconductor package substrate singulation and/or edge modification without selecting all the modules described. For example, one or more processing modules 110, 115, 120, and 125 for singulation can be used without also using other processing modules. Any module described can be a stand-alone module or a stand-alone module with inspection and/or panel or device handling capabilities. The processing modules 110, 115, 120, 125, 130 and 135 as well as the EFEMs and/or pick and places 105 and 106 of singulation system 100 include a housing connected to one or more gas, air, and/or vacuum systems that are capable of providing a controlled atmosphere, such as for example, an interior of the housing that is free of particulate matter or reactive gases. The air handling system could provide, for example, a vacuum inside the housing or an inert gas. Additionally, for explanation purposes, modules described herein have been illustrated with panels or package substrate units, however, these units will not always be present in a module.

Figure 2 illustrates a portion of an exemplary polymer ablation module 200 that is useful for removing packaging materials, such as, for example, polymer(s), from between individual packaging units housed on a panel. Exemplary polymer ablation module 200 includes a laser 205, which can be, for example, an ultraviolet laser (UV at about 300 - 400 nm), a green laser (at about 500 - 600 nm), an infrared laser (IR at about 1000 - 1080 nm) and CO₂ (at about 10,000 - 10,100 nm). As used herein, "about" indicates a value can be +/- 10 % of the indicated value. Other types of lasers are possible as is a system that employs more than one laser. In some examples, the polymer ablation module 200 employs one laser 205 which is one of the foregoing types or is a different type that is able to remove polymer from a glass surface. The exemplary polymer ablation module 200 also includes optics 210 for modifying the laser beam 215 (shown as a dotted line) emitted from the laser 205. The optics 210 can be, for example, a collimator for focusing the laser beam. The laser beam 215 will not be present when the laser 205 is not operating or powered on. The exemplary polymer ablation module 200 also includes a galvanometer scanner 220 (or galvoscanner) that is able to steer the laser beam 215 over the surface of a panel 235 (or work piece) that is undergoing processing. The panel 235 may also not be present in the exemplary polymer ablation module 200. The panel 235 is on a worktable 225 which can comprise, for example, a vacuum chuck that is capable of holding a panel 235 in place. The exemplary polymer ablation module 200 removed packaging materials from between package substrates that are housed in a panel. The removal of package materials can leave a region of a package core exposed, for example, the region of a package core that is between package substrates housed in a panel can be exposed.

Figure 3 provides a portion of an exemplary singulation conditioning module 300 that is useful for modifying the properties of a package substrate core material to enhance separation of package substrate units. The package substrate core material is, for example, a glass material. Exemplary singulation conditioning module 300 includes one or more lasers 305, which can be, for example, a UV, a green laser, and/or an IR lasers which have a pulse width of a few picoseconds or femtoseconds. Other types of lasers are possible. In some examples, the singulation conditioning module 300 employs one laser 305 which is one of the foregoing types or is a different type that is able to remove polymer from a glass surface. The exemplary singulation conditioning module 300 also includes optics 310 for modifying the laser beam 315 (shown as a dotted line) emitted from the laser 305. The optics 310 can be, for example, a collimator for focusing the laser beam. The laser beam 315 will not be present when the laser 305 is not operating or powered on. The exemplary singulation conditioning module 300 also includes a galvanometer scanner 320 (or galvoscanner) that is able to steer the laser beam 315 over the surface of a panel 335 (or work piece) that is undergoing processing. The exemplary singulation conditioning module 300 also comprises a filamentation optic 330 or a Bessel beam shaping optic 330. The laser beam 315 that is routed through a set of lenses to focus on a point on the substrate. Once a point is treated on the panel 335, the worktable 325 can move linearly according to the path specified to create a perforation curtain. The panel 335 may also not be present in the exemplary singulation conditioning module 300. The panel 335 is on a worktable 325 which can comprise, for example, a vacuum chuck that is capable of holding a panel 335 in place. The singulation conditioning module 300 can comprise a translation system that allows worktable 325 to move linearly according to a specified path.

Figure 4 illustrates an exemplary separation module for a bend-to-break process. In Figure 4, a panel 405 includes a package core 410 and package substrate material 415 (which can include, for example, buildup layers of alternating of materials such as Cu and dielectric). Package core 410 can be a glass core as described herein. Panel 405 can also include an optional laminated tape 420. A breaking pin 425 applies a force (in the direction shown by arrow 427) that causes a separation of the package core 410 in the panel singulation regions 440. Panel singulation regions 440 are between the package substrate units. In this example, package substrate units include package substrate material 415 on two sides of the package core 410. Support structures 430 hold the panel in place.

Figure 5 illustrates an exemplary separation module for a pull-to-break process. In Figure 5, a panel 505 includes a package core 510 and package substrate material 515 (which can include, for example, buildup layers of alternating of materials such as Cu and dielectric). Package core 510 can be a glass core. Panel 505 can also include an optional laminated tape 520. The panel 505 is attached to vacuum chucks 540 that are capable of translating as shown by the arrows 545 to apply tensile stress to the panel 505 causing the substrate core to separate at the dashed lines and in the regions previously modified by a laser. The panel 505 may not be present in a separation module when the separation module is not operating.

Figures 6A - 6B illustrate an edge treatment module that can perform a mechanical edge grinding on a package substrate. Figure 6A provides a top view of a plurality of package substrates and Figure 6B provides a side view of an individual package substrate. In Figure 6A, a vacuum chuck 605 holds package substrates 610 for processing. The package substrates 610 can be placed on the vacuum chuck with for example, a pick-and-place arm (not shown). An edge grinding tool 615 can traverse the spaces between individual package substrates 610 to grind edges of the substrates 610. The grinding tool 615 can be, for example, a diamond-coated router bit or a grinding pad. An arrows 625 and 626 show directions the grinding tool 615 can move between package substrates 610. As can be seen in Figure 6B, the vacuum chuck 605 includes individual vacuum chuck pedestals 640 to hold package substrates 610 and a base region 645. Vacuum can be applied through the individual vacuum chuck pedestals 640 to hold semiconductor package substrates 610 in place. The package substrate 610 includes a package substrate core 630 and package substrate material 635 (which can be, for example, buildup layers of alternating of materials such as Cu and dielectric). The distance between vacuum chuck pedestals 640 on a vacuum chuck 605 can be, for example at least 250 µm to allow space for a grinding tool. In Figure 6B, the action of the grinding tool 615 can result in the edges of the package substrate core 630 being smoothed and trimmed and cracks can be removed. Assembly 600 shows a package substrate 610 before grinding and assembly 601 shows a package substrate 611 after grinding in which package substrate core 631 is flush with the package substrate material 635. In this example, the edges of package substrate core 631 are shown trimmed flush with the package substrate material 635, however other amounts of trimming are possible in which the core is not entirely flush with the package substrate material 635.

Figure 7 provides an exemplary edge treatment module 700 that employs a laser to modify the edges of a package substrate. In Figure 7, exemplary edge treatment module 700 includes one or more lasers 705, which can be, for example, an ultraviolet laser (UV at about 100 - 400 nm), an infrared laser (IR at about 1000 - 1080 nm), and CO₂ (at about 10000 - 10,100 nm). As used herein, "about" indicates a value can be +/- 10 % of the indicated value. Other types of lasers are possible. In some examples, the edge treatment module 700 employs one laser 705 which is one of the foregoing types or is a different type that is able to remove material from and/or melt the edges of the package substrate 740. The edge treatment module 700 also includes optics 710 for modifying the laser beam 715 (shown as a dotted line) emitted from the laser 705. The optics 710 can be, for example, a collimator for focusing the laser beam. The laser beam 715 will not be present when the laser 705 is not operating or powered on. The exemplary edge treatment module 700 can also include a galvanometer scanner 720 (or galvoscanner) that is able to steer the laser beam 715 or other reflective optics that position the laser beam for processing the semiconductor package substrate. A semiconductor package substrate 740 is shown attached to a vacuum chuck 770 that is able to rotate as shown my arrow 775. The semiconductor package substrate 740 includes a package substrate core 750 and package substrate material 745 (which can include, for example, buildup layers of alternating of materials such as Cu and dielectric). In examples of the invention, the package substrate core 750 is a glass core. The package substrate 740 may also not be present in the exemplary edge treatment module 700, such as for example, when the edge treatment module 700 is not operating.

Figure 8 shows exemplary components of an edge passivation module 135 that can passivate the edges of a semiconductor package substrate by coating the edges with a polymer material. In Figure 8, a pedestal vacuum chuck 805 holds package substrates 610 for processing. Although one pedestal vacuum chuck 805 is shown, an edge passivation module 800 can have many more. A suction cup type substrate holder can also be used instead of a pedestal vacuum chuck 805. The package substrates 810 can be placed on the vacuum chuck with for example, a pick-and-place arm (not shown). The package substrate includes a package substrate core 815 and package substrate materials 820 (which can include, for example, buildup layers of alternating of materials such as Cu and dielectric). A polymer delivery system includes a movable coating head 840, which can be, for example, a roller, a spray nozzle, a needle, a sponge, a plastic (e.g., rubber or other polymer) spreader, a brush, or an inkjet printer nozzle type. Polymer is pumped into the movable coating head 840, as the coating head 840 moves around the edges of the package substrate dispensing a thin film of polymer 845. The thin film of polymer 845 can be 10 - 100 µm thick, for example. Edge passivation module 800 includes a package substrate 810 before polymer coating and assembly 801 shows a package substrate 811 after polymer coating 845 on the edges of package substrate 810. Optionally, a second coating head (not shown) can be used to shape the profile of the polymer coating 845 on the package substrate 811 edges. The shaping of the polymer coating 845 can adjust the coating geometry to meet final shape, thickness, and/or profile requirements. The polymer delivery system also includes a chemical storage and delivery system, including tubing, filters, pumps, and/or reservoirs (not shown). The polymer can be for example, a thermoset polymer or other type of heat-curable polymer.

An exemplary edge passivation module 135 also includes a polymer cure module 802 that can be, for example, an open hot plate or a batch oven 855 which can conduct heat into the package substrate 811 to cure the polymer coating 845 if the coating is, for example, a thermoset polymer. Alternatively, the polymer cure module 802 can be a UV stage 855, if the polymer coating 845 is, for example, a UV-initiated crosslinking polymer. The polymer cure module 802 can be an in-line cure module. An edge passivation module 135 polymer cure module 802 can also include a camera system 860 to capture images of the coated edges of package substrate 811. The camera system 860 can include computing and/or software to compare the coated edges of package substrate 811 to a reference image. Alternatively, the camera system, 860 can use a flat line gauge (not shown) to contact the coated edges of package substrate 811 for a thickness measurement. The package substrates 810 and 811 are shown in order to explain the operation of the exemplary edge passivation module 135, but they may not be present in an edge passivation module 135. For example, package substrates 810 and 811 might not be present in an edge passivation module 135 when the module is not processing package substrates.

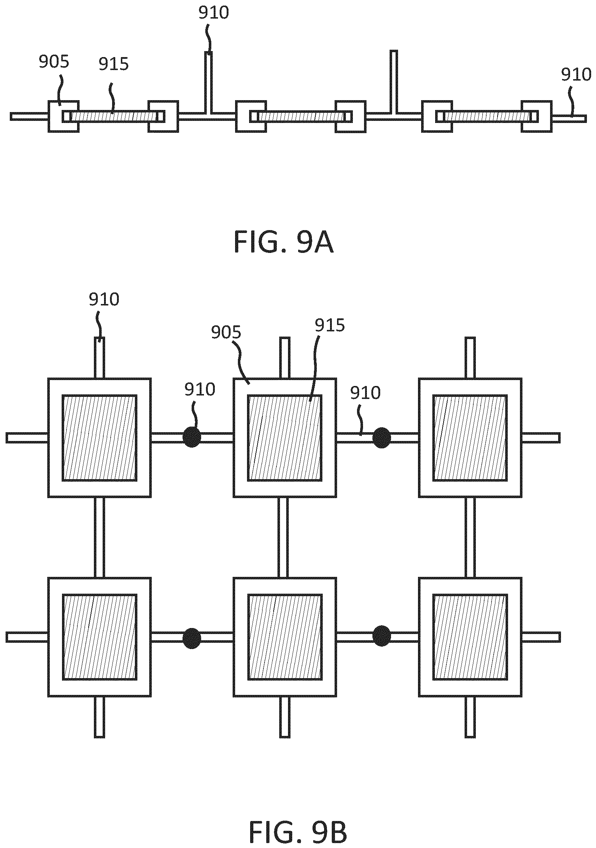

Figures 9A - 9B show exemplary components of an alternative edge passivation module 135 that can passivate the edges of a semiconductor package substrate by coating the edges with a polymer material using a thermoplastic extrusion system. Figure 9A provides a side view and Figure 9B provides a top-down view. In Figures 9A - 9B, clamp heads 905 hold semiconductor package substrate 915 and deliver a thermoplastic material to the edges of semiconductor package substrate 915 through thermoplastic delivery system 910. The thermoplastic delivery system 910 can be a pressure driven liquid material flow system that includes tubes and connection points that allow material flow. The clamp heads 905 can heat the thermoplastic polymer to melt it and squeeze it onto the edge of the semiconductor package substrate 915. The clamp heads 905 can apply a thermoplastic coating to the edges of semiconductor package substrate 915 and also shape the applied thermoplastic coating. The clamp heads 905 include a hinge (not shown) that allows them to open for releasing and inserting a semiconductor package substrate 915. When the thermoplastic cools to room temperature, it can apply a beneficial compressive stress on the package substrate 915. The package substrates 915 are shown in order to explain the operation of the exemplary edge passivation module 135, but they may not be present in an edge passivation module 135. For example, package substrates 915 might not be present in an edge passivation module 135 when the module is not processing package substrates.

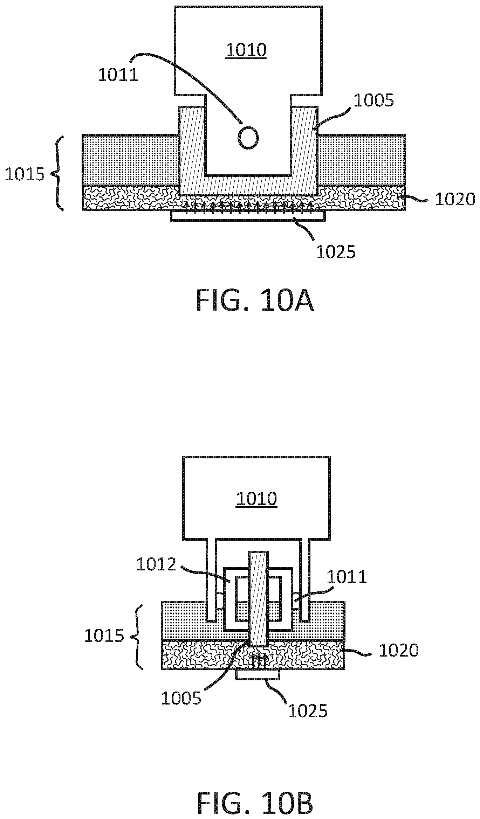

Figures 10A - 10B illustrate exemplary components of a further alternative edge passivation module 135 that can passivate the edges of a semiconductor package substrate by coating the edges with UV-curable polymer. Figure 10A provides a first side view and Figure 10B provides a second side view. In Figures 10A- 10B, a translatable and rotatable unit picker 1010 holds a semiconductor package substrate 1005 and can dip a semiconductor package substrate 1005 edge in a polymer bath 1015 comprising UV-curable polymer 1020. The movable and rotatable unit picker 1010 can rotate around axis region 1011 while grippers 1012 hold the package substrate 1005. The polymer bath 1015 can include a transparent bottom that allows irradiation of the UV-curable polymer 1020 in a selected area. The quantity of UV-curable polymer 1020 in the polymer bath 1015 can be controlled so that the amount of polymer on the package substrate 1005 is controlled. After dipping the semiconductor package substrate 1005 into the polymer bath 1015, a UV light 1025 that is for example, a digital light processing (DLP) module, a stereolithography (SLA) module, a monochromatic liquid crystal display (LCD) screen, or a UV laser can selectively irradiate the UV-curable polymer to cure and adhere the polymer to the edges of the package substrate 1005. A package substrate 1005 is shown in Figures 10A - 10B, as well as polymer 1020 in the polymer bath 1015, but these may not always be present in an edge passivation module 135.

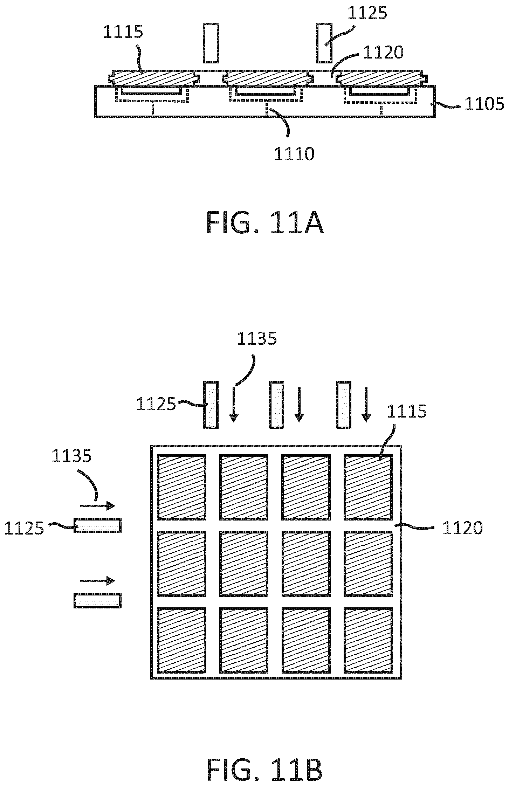

Figures 11A - 11B illustrate exemplary components of a further alternative edge passivation module 135 that can passivate the edges of a semiconductor package substrate by coating the edges with UV-curable polymer. Figure 11A provides a first side view and Figure 11B provides a top-down view. In Figure 11A, a vacuum stage 1105 has vacuum lines 1110 (shown as dashed lines) that can hold semiconductor package substrates 1115 during processing without allowing mechanical movement. The semiconductor package substrates 1115 have been singulated through laser polymer ablation followed by a laser glass cutting to generate a pull-back structure (a non-flush edge). Polymer is deposited into regions 1120 between semiconductor package substrates 1115 through polymer dispensers 1125. Polymer dispensers 1125 can be inkjet printing heads, needle dispenser heads, or aerosol jetting heads, for example. In Figure 11B, arrows 1135 show the direction that polymer dispensers 1125 can move between immobilized semiconductor package substrates 1115. After the polymer in regions 1120 is cured, semiconductor package substrates 1115 can be separated (singulated) through a dicing method, such as for example, blade dicing, laser cutting, or waterjet cutting. The resulting semiconductor package substrates have a flush edge.

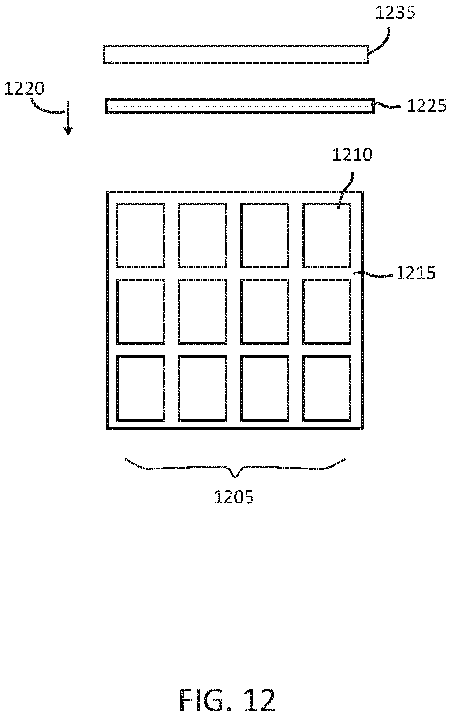

Figure 12 shows exemplary components of an additional alternative edge passivation module 135 that can passivate the edges of a semiconductor package substrate by coating the edges with UV-curable polymer. A mask 1205 contains regions that are impervious to polymer 1210 and regions that dispense polymer 1215. Semiconductor package substrates are housed beneath the mask 1205 and not are visible in Figure 12. A polymer material spreader 1225 traverses the mask 1205 surface. A UV lamp 1235 can be used to cure the polymer. Arrow 1220 indicate a direction that polymer material spreader 1225 traverses the mask surface.

Further additional coating devices include flexible contact coating heads for glass package substrate core edge coating. A variety of flexible and soft coating head designs are possible that include, for example, thin brushes, sponges, rubber (polymer or plastic material) tips, and felt tips. These flexible tip designs can reduce the risk of coating overflow as coating gets dispensed in the region of contact between the coating head and the edge. Moreover, for the sponge and thin brush type, complex geometries can be coated in a single pass as the coating head can deform and adhere to the edge of the package substrate unit.

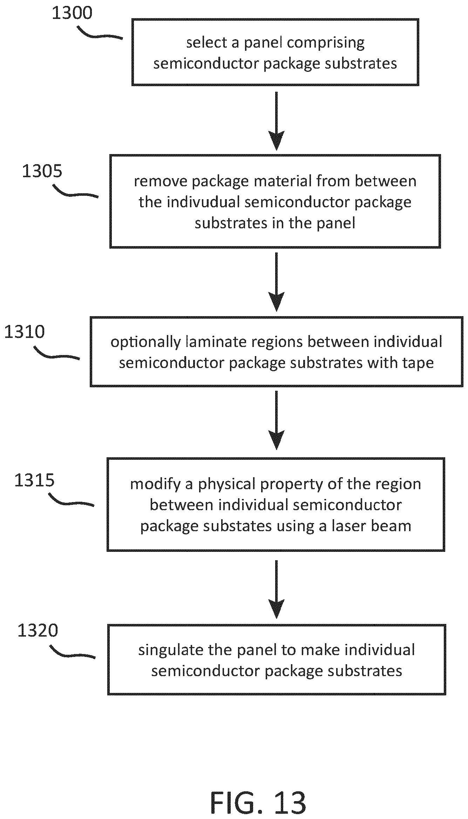

Figure 13 describes a method for singulating semiconductor package substrates from a panel. The method of Figure 13 is useful, for example, for semiconductor package substrates that have a core that is a glass material as described herein. In addition to the following description, the devices and processes described with respect to Figures 1 - 5 herein provide additional details. A method for singulating semiconductor package substrates from a panel includes selecting a panel comprising semiconductor package substrates 1300. The semiconductor package substates can include a glass package substrate core. Package material is removed from the regions between the individual package substrates 1305. The package material includes, for example, buildup layers of alternating materials such as Cu and dielectric. Figures 1-2 and accompanying description provide example devices and method details about removing material from between semiconductor package substrates and from the surface of a semiconductor package core leaving the semiconductor package core exposed in the regions between the semiconductor package substrates. Optionally, the exposed regions in between the semiconductor package substrates can be laminated with tape 1310. The tape can be, for example, a UV release tape. A physical property of the regions in between the individual semiconductor package substrates is modified using a laser beam 1315. Figures 1 and 3 and accompanying description herein provide additional details of an exemplary system for modifying physical properties of a semiconductor package core substrate. The modified core material has a physical structure that makes singulation easier than it was before modification. The selected panel is then singulated 1320 to create individual package substrate units. Exemplary singulation modules and processes are described herein with respect to Figures 1 and 4-5. Other methods are possible.

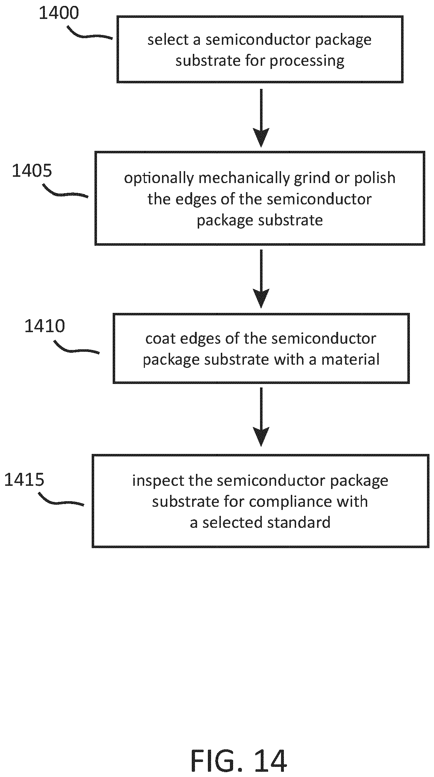

Figure 14 diagrams a method for semiconductor package substrate edge modification. The semiconductor package substrates can be, for example, the semiconductor package substrates that have been singulated according to the devices and processes described herein (for example with respect to Figures 1 - 5 and 13). In addition to the following description, the devices and processes described with respect to Figures 1, 6A - 6B, 7 - 8, 9A - 9B, 10A - 10B, 11A - 11B and 12, herein provide additional details. The method of Figure 14 is useful, for example, for semiconductor package substrates that have a core comprised of a glass material as described herein. One or more semiconductor package substrates are selected for processing 1400. Typically processing occurs on a plurality of substrates. Optionally, the edges of the semiconductor package substrate are treated, by, for example grinding or polishing 1405. The edge of the semiconductor package substrate can be flush or the semiconductor package substrate core can protrude from the edge. Edges of the semiconductor package substrate are coated with a material 1410. The coating material can be a polymeric material, such as for example a UV-curable or heat-curable polymer. The semiconductor package substrate is inspected for compliance with selected standards 1415. The selected standard can be one that is important to the viability or function of the semiconductor package substrate. More than one standard or characteristic can be selected for the inspection. For example, a package substrate can be inspected for warpage and/or core cracking and chipping.

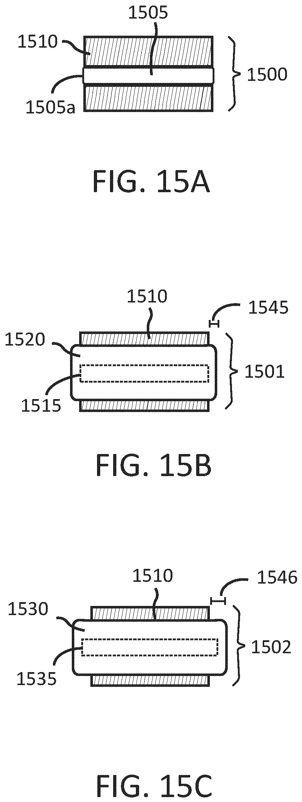

Figures 15A - 15C illustrate exemplary semiconductor package substrates. In Figure 15A, a semiconductor package substrate 1500 has a substrate core 1505 and layers 1510. Layers 1510 can be layers of dielectric material having conductive structures on, through, and/or embedded within the layers of dielectric material. Conductive structures include conducting traces and conducting vias. The dielectric layers can be, for example, build-up layers and the conducting traces and vias in the buildup layers can be a metal such as copper. For example, ABF is a material that can be used for build-up layers. Edges (indicated by 1505a) of the substrate core 1505 are modified by processing that has removed material from the edges and/or remelted the edges. The substrate core 1505 can have different dimensions, for example, it could extend beyond the layers 1510 on core edges 1505a. The processing can be; for example, the type of mechanical and/or laser processing that is shown in and described herein with respect to Figure 6 or 7.

Figure 15B shows a further example of a semiconductor package substrate 1501 having a substrate core 1515 (shown by a dashed line). Coating 1520 is on the edges of substrate core 1515. In Figure 15C, the substrate core 1535 (indicated by a dashed line) extends further than the layers 1510. Coating 1530 is on substrate core 1535. The coatings 1520 and 1530 can have different dimensions, for example, they could be taller and cover more of the edges of the semiconductor package substrate 1501 and/or package substrate 1502. The semiconductor package substrate that has been coated could be the semiconductor package substrate of Figure 15A or a different one, such as one that has not been modified by mechanical or laser edge treatment. Coatings 1520 and 1530 can be comprised of a polymeric material. The polymeric material can be, for example, a UV-curable material, a thermoset material, or heat-curable material. Polymeric materials also include acrylic or epoxy-resin based materials. The coatings 1520 and 1530 can have a thickness (indicated by 1545 or 1546) of 10 µm - 100 µm, for example. Package substrate cores 1505, 1515, and 1530 can be a glass material as described herein.

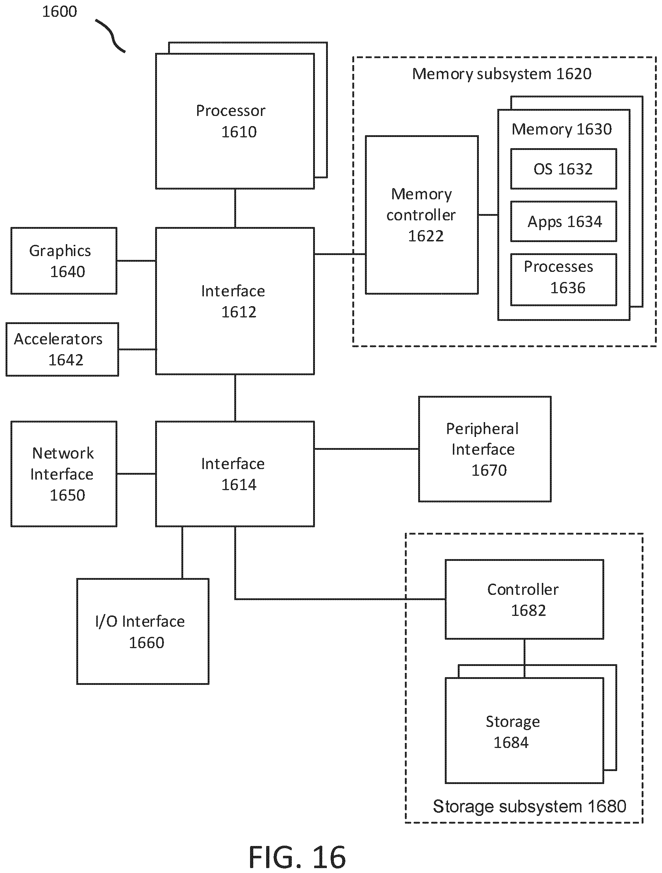

Figure 16 depicts an example computing system which can be used in conjunction with any of the processing equipment or modules described herein. For example, instructions for inspecting semiconductor package substrates for compliance with one or more predetermined measured values can be stored and/or run on the computing system. The computing system 1600 can schedule and manage transfer of panels and/or package substrates between units and run process recipes. Additionally processors and other semiconductor chips in the computing system 1600 can include package substrates as described herein and with respect to Figures 15A - 15C. The computing system employed can include more, different, or fewer features than the one described with respect to Figure 16.

Computing system 1600 includes processor 1610, which provides processing, operation management, and execution of instructions for system 1600. Processor 1610 can include any type of microprocessor, CPU (central processing unit), GPU (graphics processing unit), processing core, or other processing hardware to provide processing for system 1600, or a combination of processors or processing cores. Processor 1610 controls the overall operation of system 1600, and can be or include, one or more programmable general-purpose or special-purpose microprocessors, digital signal processors DSPs, programmable controllers, application specific integrated circuits (ASICs), programmable logic devices (PLDs), or the like, or a combination of such devices.

In one example, system 1600 includes interface 1612 coupled to processor 1610, which can represent a higher speed interface or a high throughput interface for system components needing higher bandwidth connections, such as memory subsystem 1620 or graphics interface components 1640, and/or accelerators 1642. Interface 1612 represents an interface circuit, which can be a standalone component or integrated onto a processor die. Where present, graphics interface 1640 interfaces to graphics components for providing a visual display to a user of system 1600. In one example, the display can include a touchscreen display.

Accelerators 1642 can be a fixed function or programmable offload engine that can be accessed or used by a processor 1610. For example, an accelerator among accelerators 1642 can provide data compression (DC) capability, cryptography services such as public key encryption (PKE), cipher, hash/authentication capabilities, decryption, or other capabilities or services. In some cases, accelerators 1642 can be integrated into a CPU socket (e.g., a connector to a motherboard (or circuit board, printed circuit board, mainboard, system board, or logic board) that includes a CPU and provides an electrical interface with the CPU). For example, accelerators 1642 can include a single or multi-core processor, graphics processing unit, logical execution unit single or multi-level cache, functional units usable to independently execute programs or threads, ASICs, neural network processors (NNPs), programmable control logic, and programmable processing elements such as field programmable gate arrays (FPGAs) or programmable logic devices (PLDs). Accelerators 1642 can provide multiple neural networks, CPUs, processor cores, general purpose graphics processing units, or graphics processing units can be made available for use by artificial intelligence (Al) or machine learning (ML) models.

Memory subsystem 1620 represents the main memory of system 1600 and provides storage for code to be executed by processor 1610, or data values to be used in executing a routine. Memory subsystem 1620 can include one or more memory devices 1630 such as read-only memory

(ROM), flash memory, one or more varieties of random access memory (RAM) such as static RAM (SRAM), dynamic RAM (DRAM), synchronous DRAM (SDRAM) and/or or other memory devices, or a combination of such devices. Memory 1630 stores and hosts, among other things, operating system (OS) 1632 that provides a software platform for execution of instructions in system 1600, and stores and hosts applications 1634 and processes 1636. In one example, memory subsystem 1620 includes memory controller 1622, which is a memory controller to generate and issue commands to memory 1630. The memory controller 1622 could be a physical part of processor 1610 or a physical part of interface 1612. For example, memory controller 1622 can be an integrated memory controller, integrated onto a circuit within processor 1610.

System 1600 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interface (PCI) or PCI express (PCIe) bus, a Hyper Transport or industry standard architecture (ISA) bus, a small computer system interface (SCSI) bus, a universal serial bus (USB), or a Firewire bus.

In one example, system 1600 includes interface 1614, which can be coupled to interface 1612. In one example, interface 1614 represents an interface circuit, which can include standalone components and integrated circuitry. In one example, user interface components or peripheral components, or both, couple to interface 1614. Network interface 1650 provides system 1600 the ability to communicate with remote devices (e.g., servers or other computing devices) over one or more networks. Network interface 1650 can include an Ethernet adapter, wireless interconnection components, cellular network interconnection components, USB, or other wired or wireless standards-based or proprietary interfaces. Network interface 1650 can transmit data to a device that is in the same data center or rack or a remote device, which can include sending data stored in memory.

Some examples of network interface 1650 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that could have been performed by a CPU. The IPU or DPU can include one or more memory devices.

In one example, system 1600 includes one or more input/output (I/O) interface(s) 1660. I/O interface 1660 can include one or more interface components through which a user interacts with system 1600 (e.g., audio, alphanumeric, tactile/touch, or other interfacing). Peripheral interface 1670 can include additional types of hardware interfaces, such as, for example, interfaces to semiconductor fabrication equipment and/or electrostatic charge management devices.

In one example, system 1600 includes storage subsystem 1680. Storage subsystem 1680 includes storage device(s) 1684, which can be or include any conventional medium for storing data in a nonvolatile manner, such as one or more magnetic, solid state, and/or optical based disks. Storage 1684 can be generically considered to be a "memory," although memory 1630 is typically the executing or operating memory to provide instructions to processor 1610. Whereas storage 1684 is nonvolatile, memory 1630 can include volatile memory (e.g., the value or state of the data is indeterminate if power is interrupted to system 1600). In one example, storage subsystem 1680 includes controller 1682 to interface with storage 1684. In one example controller 1682 is a physical part of interface 1612 or processor 1610 or can include circuits or logic in both processor 1610 and interface 1614.

A power source (not depicted) provides power to the components of system 1600. More specifically, power source typically interfaces to one or multiple power supplies in system 1600 to provide power to the components of system 1600.

Exemplary systems may be implemented in various types of computing, smart phones, tablets, personal computers, and networking equipment, such as switches, routers, racks, and blade servers such as those employed in a data center and/or server farm environment.

Flow diagrams as illustrated herein provide examples of sequences of various process actions. The flow diagrams can indicate operations to be executed by a software or firmware routine, as well as physical operations. Physical operations can be performed by semiconductor processing equipment that is controlled by a computing system. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted and not all implementations will perform all actions.

Various components described can be a means for performing the operations or functions described. Each component described can include software, hardware, or a combination of these. Some components can be implemented as software modules, hardware modules, special-purpose hardware (for example, application specific hardware, application specific integrated circuits (ASICs), DSPs), embedded controllers, or hardwired circuitry).

To the extent various computer operations or functions are described herein, they can be described or defined as software code, instructions, configuration, and/or data. The software content can be provided via an article of manufacture with the content stored thereon, or via a method of operating a communication interface to send data via the communication interface. A machine-readable storage medium can cause a machine to perform the functions or operations described. A machine-readable storage medium includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). Instructions can be stored on the machine-readable storage medium in a non-transitory form. A communication interface includes any mechanism that interfaces to, for example, a hardwired, wireless, or optical medium to communicate to another device, such as, for example, a memory bus interface, a processor bus interface, an Internet connection, a disk controller.

### EXAMPLES

A package substrate comprises a package substrate core. The package substrate core is comprised of a glass material and the package substrate core has edges. The package substrate also comprises layers of dielectric material on a surface of the package substrate core, wherein at least one of the layers of dielectric material has a conducting trace in the layer of dielectric material; and a polymer coating wherein the polymer coating is on the edges of the of the package substrate core. The glass material can be a solid amorphous glass material. The glass material can comprise aluminosilicate, borosilicate, alumino-borosilicate, silica, or fused silica. The package substrate core can have a thickness between 50 µm and 1.4 mm. The polymer coating can comprise a heat-curable or ultra-violet-curable polymer. The polymer coating can have a thickness that is between 10 µm and 100 µm. The package substrate core can extend beyond the layers of dielectric material. The glass material can also comprise Al₂O₃, B₂O₃, MgO, CaO, SrO, BaO, SnO₂, Na₂O, K₂O, SrO, P₂O₃, ZrO₂, Li₂O, Ti, or Zn.

A method for separating semiconductor package substrates from a panel comprising a plurality of semiconductor package substrates can comprise: removing dielectric layers from between package substrates wherein removing dielectric layers leaves a surface of a package substrate core exposed; altering a physical property of the package substrate core wherein altering occurs in exposed regions between package substrates and wherein altering occurs through exposure to a laser beam; and separating the package substrates from the panel to form individual package substrate units. The package substrate core can be a solid amorphous glass material. Removing dielectric layers from between package substrates can comprise ablating the dielectric layers with a laser beam. The method for separating semiconductor package substrates from a panel can also comprise laminating the panel comprising a plurality of semiconductor package substrates with an ultra violet release tape. Separating the package substrates from the panel can comprise bending the panel to cause the package substrate core to break. Separating the package substrates from the panel can comprise subjecting exposed regions between package substrates to a thermal stress using a laser beam. The method can also include grinding one or more edges of the individual package substrate units. The method can also include coating one or more edges of the individual package substrate units with a polymeric material.

An assembly for coating an edge of a semiconductor package substrate can comprise: a housing that is capable of providing a controlled atmosphere; at least one vacuum chuck that is capable of holding a semiconductor package substrate; a polymer delivery system wherein the polymer delivery system comprises a coating head that is capable of coating an edge of a semiconductor package substrate with a polymer; a polymer cure module wherein the polymer cure module is capable of irradiating the semiconductor package substrate with ultra violet light or wherein the polymer cure module is capable of applying heat to the semiconductor package substrate to cause the polymer to cure. The coating head can be a spray coating head, a roller coating head, a plastic spreader, a sponge, or a brush coating head. The assembly can also include a pick and place system that is capable of placing a semiconductor package substrate on a vacuum chuck pedestal. The assembly can also include an inspection module wherein the inspection module comprises a camera.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. A package substrate comprising:
a package substrate core wherein the package substrate core is comprised of a glass material and wherein the package substrate core has edges;
layers of dielectric material on a surface of the package substrate core, wherein at least one of the layers of dielectric material has a conducting trace in the layer of dielectric material; and
a polymer coating wherein the polymer coating is on the edges of the of the package substrate core.

2. The package substrate of claim 1 wherein the polymer coating comprises a heat-curable or ultra-violet-curable polymer.

3. The package substrate of claim 1 wherein the polymer coating has a thickness that is between 10 µm and 100 µm.

4. The package substrate of claim 1 wherein the package substrate core extends beyond the layers of dielectric material.

5. The package substrate of any of claims 1 - 4, wherein the glass material is a solid amorphous glass layer.

6. A method for separating semiconductor package substrates from a panel comprising a plurality of semiconductor package substrates comprising:
removing dielectric layers from between package substrates wherein removing dielectric layers leaves a surface of a package substrate core exposed;
altering a physical property of the package substrate core wherein altering occurs in exposed regions between package substrates and wherein altering occurs through exposure to a laser beam; and
separating the package substrates from the panel to form individual package substrate units.

7. The method of claim 6 wherein separating the package substrates from the panel comprises bending the panel to cause the package substrate core to break.

8. The method of claim 6 wherein separating the package substrates from the panel comprises subjecting exposed regions between package substrates to a thermal stress using a laser beam.

9. The method of claim 6 also including grinding one or more edges of the individual package substrate units.

10. The method of claim 6 also including coating one or more edges of the individual package substrate units with a polymeric material.

11. The method of any of claims 6 - 10 wherein the package substrate core is a solid amorphous glass layer.

12. An assembly for coating an edge of a semiconductor package substrate comprising:
a housing that is capable of providing a controlled atmosphere;
at least one vacuum chuck that is capable of holding a semiconductor package substrate;
a polymer delivery system wherein the polymer delivery system comprises a coating head that is capable of coating an edge of a semiconductor package substrate with a polymer; and
a polymer cure module wherein the polymer cure module is capable of irradiating the semiconductor package substrate with ultra violet light or wherein the polymer cure module is capable of applying heat to the semiconductor package substrate to cause the polymer to cure.

13. The assembly of claim 12 wherein the coating head is a spray coating head, a roller coating head, a plastic spreader, a sponge, or a brush coating head.

14. The assembly of claim 12 also including a pick and place system that is capable of placing a semiconductor package substrate on a vacuum chuck pedestal.

15. The assembly of claim 12 also including an inspection module wherein the inspection module comprises a camera.
